# EUROPEAN PATENT SPECIFICATION

(11) **EP 0 814 544 B1**
(45) Date of publication and mention of the grant of the patent: **21.08.2002**
(21) Application number: 97109746.4
(22) Date of filing: 16.06.1997
(51) Int. Cl.: H01S 5/02

(54) **Semiconductor laser with facet coating and method for making the same**
Halbleiterlaser mit Spiegelbeschichtung und dessen Herstellungsverfahren
Lasers à semi-conducteur avec un revêtement des facettes et méthode de fabrication

(30) Priority: 22.06.1996 EP 96110150
(43) Date of publication of application: 29.12.1997
(73) Proprietor: International Business Machines Corporation, Armonk, N.Y. 10504 (US)
(72) Inventor: Dietrich, Hans Peter, 8134 Adliswil (CH); Latta, Ernst-Eberhard, 8134 Adliswil (CH); Gasser, Marcel, 8041 Zürich (CH); Roentgen, Peter, 8800 Thalwil (CH); Jakubowicz, Abram, 8803 Rüschlikon (CH)
(74) Representative: Klett, Peter Michael

(56) References cited:
- EP-A- 0 349 193
- WO-A-97/10630
- US-A- 3 943 462
- US-A- 4 337 443
- US-A- 5 063 173
- STOLYAROV S N: "INFLUENCE OF INTERFERENCE COATINGS ON THE OPTICAL STRENGTH OF SEMICONDUCTOR LASER MIRRORS" SOVIET JOURNAL OF QUANTUM ELECTRONICS, NEW YORK, NY, US, vol. 18, no. 8, August 1988, pages 1021-1025, XP000001090

## Description

### TECHNICAL FIELD

The invention concerns a method for the application of special layers on the facets of semiconductor laser diodes for reduction of catastrophic optical mirror damage (COMD). Furthermore, it concerns semiconductor laser diodes comprising such special layers.

### BACKGROUND OF THE INVENTION

Semiconductor laser diodes have found applications in a wide variety of information handling systems because of their compact size and because their technology is compatible with that of the associated electronic circuitry. They are being employed in areas such as data communications, optical storage and optical printing. Most commonly used are group III/V compound materials. Particularly AlGaAs lasers have found extensive usage.

Historically, the mirror facets have been obtained by cleaving the laser bars, i.e., layered structures forming the active waveguide of the device. Cleaving usually provides single, often high quality devices which require, however, further individual processing and testing. More recently, there is a strong trend to increase the scale of integration which requires the replacement of at least one cleaved mirror facet of the laser diodes by an etched mirror. Since substantial progress has been made in obtaining good quality etched mirrors, this technology is very promising. It allows processes like mirror coating and testing to be performed on the wafer level - with the benefit of reduced handling, increased yield, and decreased fabrication and testing costs.

For both types of lasers, i.e., those with cleaved and those with etched mirrors, one of the most important and critical device criteria is the reliability and thus the maximum lifetime of the device at the output power levels required for the various applications. Reliability and device lifetime are heavily affected by mirror contamination and degradation which lead to device heating and finally to device destruction.

Over a long period of time, in fact for more than 15 years, proposals and attempts have been made trying to solve these problems. Most successful has been the coating of the mirror facets with passivation layers which are applied to protect the mirror surfaces against contamination during the lifetime of the device. For this standard passivation the power dissipated at the mirror turned out to be responsible for a gradual degradation close to the facet. This degradation may lead to a catastrophic optical mirror damage (COMD), as described in "Thermodynamics approach to catastrophic optical mirror damage of AlGaAs single quantum well lasers", A. Moser, E.-E. Latta, D. J. Webb, Applied Physical Letters, Vol. 55, No. 12, p. 1152, 1989.

US Patent 4,337,443 discloses a semiconductor laser element which includes a film of an amorphous material deposited on at least an optical output facet of the laser element and contains silicon and hydrogen as the indispensable components. The thickness of the amorphous film is restricted to (λ/4)·m where λ represents wavelength of laser light in the amorphous film and m represents an odd integer.

US Patent 3,943,462 relates to a semiconductor injection laser that on one facet is coated with a metallic reflecting layer and quarter-wavelength thickness layers and on the other facet with three quarter wave dielectric layers. Thus, the layers are restricted to λ/4 thickness layers.

The European Patent Application with publication number 0 349 193 describes a multi-layered dielectric film that is coated on the end surfaces of optical products. The film consists of two kinds of dielectric layer, one of which is a first dielectric layer of TiO₂ or ZnS with high refractive index n₁ and the other of which is a second dielectric layer of AL₂O₃ with low refractive index n₁. The first and second dielectric layer are deposited to a thickness of λ/4.

The time dependent COMD event, observed at semiconductor laser diodes with standard passivation, can be completely suppressed by application of the in-situ passivation process described and claimed in the US patent 5063173 with title "Method for Mirror Passivation of Semiconductor Laser Diodes", and the corresponding counterpart patents in various countries. For devices which were passivated in-situ, an absolute COMD level exists. The laser can be operated below this COMD level without any mirror damage, i.e., the laser devices which were passivated in-situ are very reliable. Lifetimes of up to 2 1/2 years have been recorded under tough conditions in a long distance fiber link where the semiconductor lasers are employed as pump lasers in pump modules.

The above mentioned absolute COMD level depends on the physical properties of the passivation layer used. For increasing absorption the absolute COMD level moves downward. In todays semiconductor lasers, damages and/or degradation at the laser facet where the light wave is decoupled from the standing light wave within the laser's cavity occur due to the relatively high intensity at the facet.

To the best of our knowledge, semiconductor lasers so far built or reported, still suffer from a number of deficiencies :
- Continuous operation output powers of above 200 mW are still not possible for an extended period of time;
- There is still room for improvement of the device lifetimes.

It is a main object of the present invention to provide reliable semiconductor diode lasers and a method for the fabrication of reliable semiconductor diode lasers.

It is another object of the present invention to provide high-power, long lifetime, high performance semiconductor diode lasers and a method for the fabrication of such high-power, long lifetime, high performance semiconductor diode lasers.

### SUMMARY OF THE INVENTION

The invention as claimed is intended to meet these objectives and to remedy the deficiencies of known semiconductor laser diodes and known fabrication techniques. The inventive method is defined by the features of claim 10 and solves the problems hitherto encountered.

The main advantages offered by the invention are that semiconductor laser diodes fabricated in accordance with the inventive process, have a significantly increased COMD level and exhibit a substantially improved degradation behavior, resulting in very high power lasers of superior reliability and thus increased lifetime.

### DESCRIPTION OF THE DRAWINGS

The invention is described in detail below with reference to drawings which illustrate a specific embodiment as well as performance characteristics of devices fabricated in accordance with the teaching of the invention, and in which
- **Fig. 1**: is a perspective view of a laser bar having a ridge GRINSCH structure to which the inventive method can be applied.
- **Fig. 2A**: is a schematic cross-section of the ridge waveguide of a semiconductor laser diode with conventional reflectivity modifications layers formed on the laser facets.
- **Fig. 2B**: is a schematic diagram illustrating the amplitude squared versus the cavity length L of a semiconductor laser diode with conventional reflectivity modifications layers formed on the laser facets.
- **Fig. 3A**: is a schematic cross-section of the ridge waveguide of a semiconductor laser diode with an inventive stack of reflectivity modifications layers formed on the laser facets.
- **Fig. 3B**: is a schematic diagram illustrating the amplitude squared versus the cavity length L of a semiconductor laser diode with an inventive stack of reflectivity modifications layers formed on the laser facets.

### DETAILED DESCRIPTION

Before describing the invention in greater detail, the purpose and the basic concept underlying the invention will be briefly outlined.

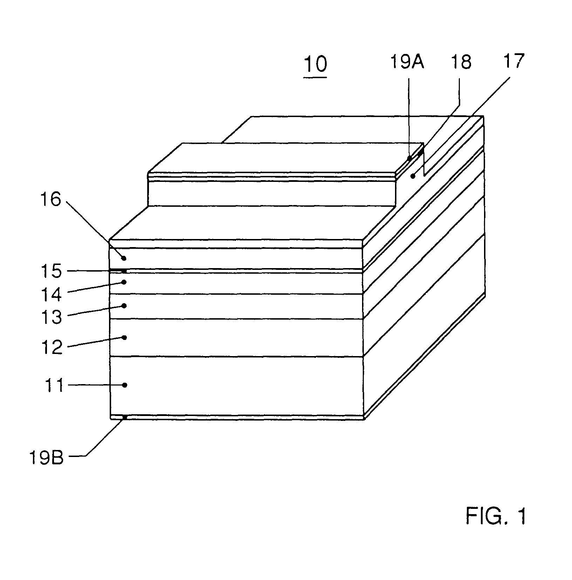

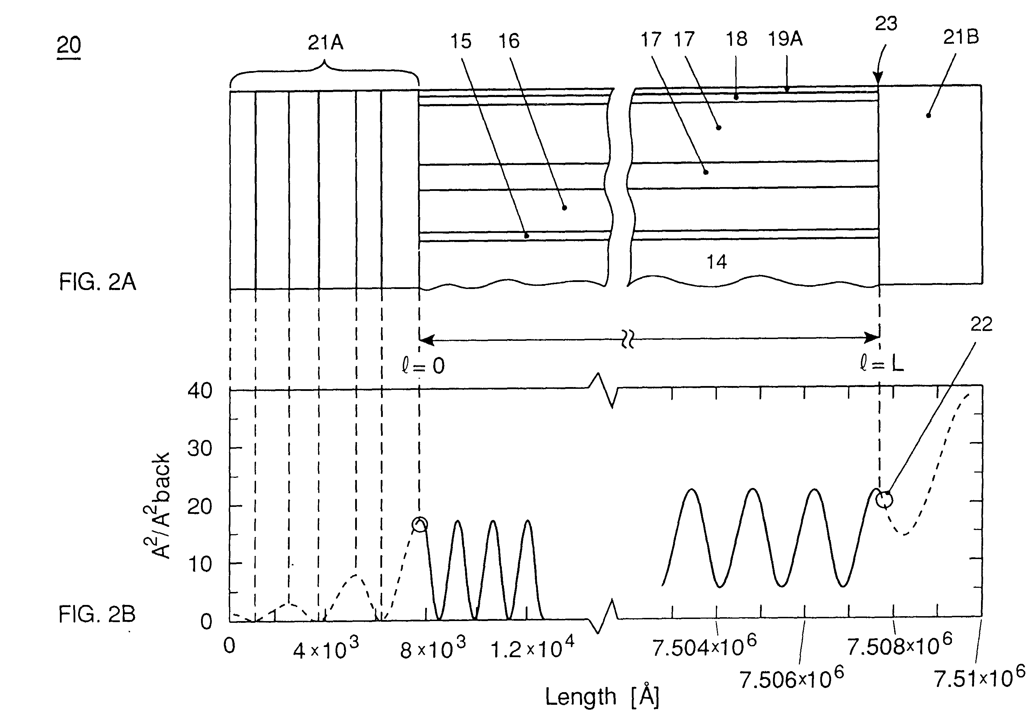

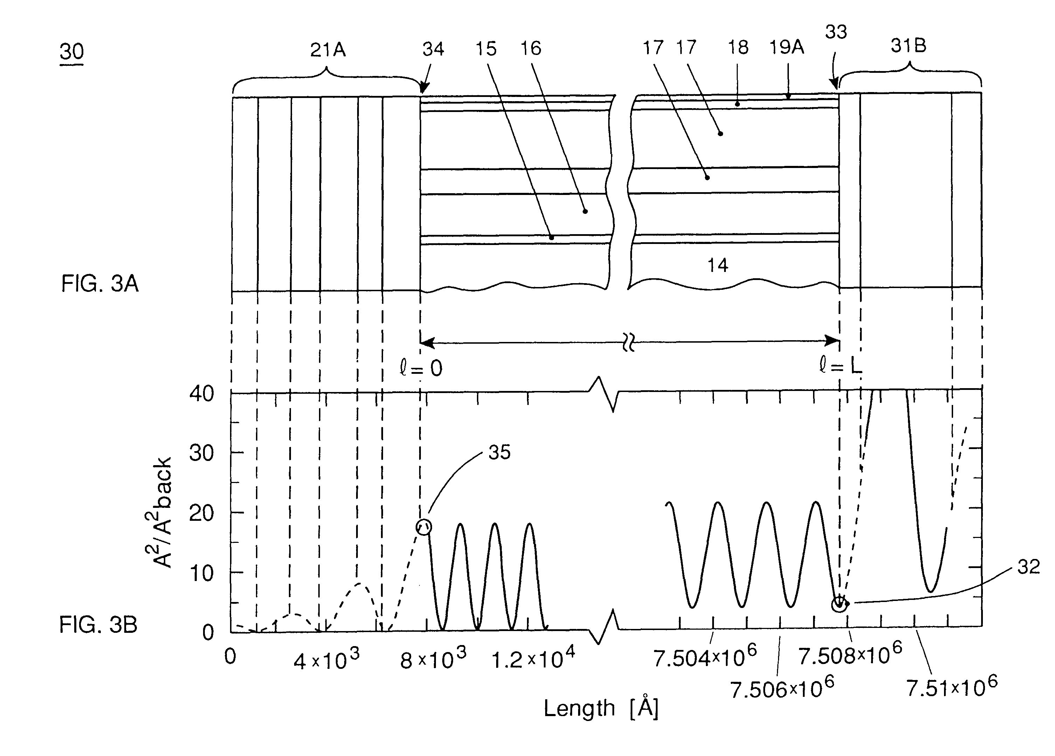

The present invention is based on the idea of using a stack of layers, deposited on one or both of the laser facets, to obtain a phase shift of the standing light wave in the laser's waveguide. It has been demonstrated by the inventors, that due to a suited phase shift, a power reduction at the interface between the laser facet and the waveguide can be achieved. The principle of the present invention will now be described with help of Figures 2 and 3. For sake of simplicity, the reference numbers of Figure 1 are also used in Figures 2 and 3.

In Figure 2A, the ridge waveguide of a semiconductor laser diode 20, which was part of the laser bar 10 (see Figure 1) with conventional reflectivity modifications layers 21A and 21B is shown. Such conventional reflectivity modification layers 21A and 21B usually consist of a stack of quarter wavelength layers. In Figure 2B, the squared amplitude of the standing light wave inside the cavity of the laser 20 is shown. In this Figure, the squared amplitude as function of the position I is given. As can be seen in Figure 2B, decoupling of the light wave is done in an intensity maximum (circle 22) of the standing wave at the front facet 23 of the laser diode 20. As a consequence of this, the highest possible power density appears at the critical interface 23 between the waveguide inside the laser 20 and the laser front facet coating 21B. It has been demonstrated that COMD occurs right at this critical interface 23.

By application of a stack of phase shifting reflectivity modification layers 31B, as illustrated in Figure 3A, the decoupling of the light wave is shifted to the intensity minimum (circle 32) of the standing wave, as illustrated in Figure 3B. In a laser 30 comprising the inventive stack of phase shifting reflectivity modification layers 31 B, the rear facet 34 instead of the front facet 33 experiences the higher power (circle 35). Please note, that on the rear facet conventional reflectivity modifications layers 21A are employed. This means that the COMD not longer appears at the front facet 33, but is observed at the rear facet 34.

By means of an adequate stack of phase shifting reflectivity modification layers also formed on the rear facet, allows decoupling at almost zero intensity, such that the 'weakest' point again would appear at the front facet 33.

It has been shown, that the total reduction in intensity at the critical interface is a factor of 4-5 for todays lasers with 10%/90% reflectivity modification layers. Laser diodes having inventive phase shifting reflectivity modification layers either on the front facet or on the front and back facets showed drastically improved reliability. Even if ramped into COMD, no damage was found at the front facet. Due to the present invention, high power, semiconductor laser diodes of 1W and more can be realized.

In the following, important steps in the fabrication process of AlGaAs (or other III/V compound) semiconductor laser diodes, according to the present invention, are described. The preparation of the laser facets (mirrors) is usually done by cleaving. Instead of cleaving the facets, they can also be made by means of etching. Details of the fabrication process of an AlGaAs laser are given in the above mentioned US patent 5063173.

First, a laser bar is produced, i.e., an epitaxially grown layered structure forming a waveguide which, when both its ends are terminated with a mirror facet, serves as the laser cavity. Such bar structure 10 is schematically shown in Figure 1. It can be the same and fabricated using the same process as that described in an article by C.Harder et al, entitled "High-Power Ridge-Waveguide AlGaAs GRINSCH Laser Diode", published in Electronics Letters, 25th September 1986, Vol.22, No.20, pp 1081-1082.

Briefly, the sequence of steps for producing the layered structure 10 is as follows:

The layers are grown on an n+ -doped GaAs substrate 11 by, e.g., molecular beam epitaxy (MBE). First, an n-doped GaAs buffer layer 12 is grown on the substrate. Next is a lower, n-type AlGaAs cladding layer 13. The core of the laser consists of a graded n-type AlGaAs region 14, an undoped region 15, forming a GaAs quantum well, and a graded p-type AlGaAs region 16. Next is the AlGaAs top cladding layer 17, followed by a p + -GaAs contact layer 18 with a doping density that is high enough for a titanium-platinum-gold electrode 19A to make good ohmic contact. Another ohmic contact 19B, at the bottom of the n-type substrate 11, is obtained by alloying germanium, gold and nickel, for example.

When needed for lateral waveguiding, a ridge having a width of a few µm can be formed on top of the structure 10, as shown in Figure 1, prior to applying the metal contact electrodes. The ridge is obtained by first applying a photoresist mask to define the ridge. Subsequently, 1 or 2 µm of the exposed top layers are etched, etching being stopped above the graded-index part of the the top cladding layer.

A cell comprising several laser bars (one such laser bar 10 is shown in Figure 1), mounted in a carrier, for example, may now be placed in a UHV (ultrahigh-vacuum) chamber. After having cleaved the laser bars in order to provide cleaved laser facets, a suited passivation layer(s) may now be deposited onto the cleaved facet(s), as described in US patent 5063173, for example. With the deposition of the passivation layer(s) the fabrication of a conventional laser diode is completed.

Next, phase shifting reflectivity modification layers are either deposited on the front facet, or on the front and rear facets. The front facet reflectivity of 10%, including the phase shift according to the present invention, can be obtained by sputter deposition of the following three-layer stack 31B, for example: 600 TiO₂ (n=2.455), 2700 Al₂O₃ (n=1.65), and 600 TiO₂ (n=2.455).

The standard six-layer stack 21A for a 90% back facet reflectivity can also be produced by sputter deposition of the following layer sequence: 1476 Al₂O₃ (n=1.65), 998 TiO₂ (n=2.455), 1655 SiO₂ (n=1.48), 998 TiO₂ (n=2.455), 1655 SiO₂ (n=1.48), and 998 TiO₂ (n=2.455).

The application of the present invention is not limited to cleaved mirror devices. Any mirror facet can be processed in accordance with the present invention.

A process for fabricating high power etched mirror lasers with a stack of layers, according to the present invention can comprise the following process steps :
- Fabrication of the basic layered laser structure (as described in C.Harder et al, cited above);
- Dry etching to produce the etched mirror facets (as described in European patent 363547, issued on 29 December 1993 and assigned to the present applicant);
- Sputter cleaning of the etched facets to remove residuals of the etching process, e.g., with nitrogen/hydrogen ions, at 800 V and a pressure of 0.4 Pa, followed by annealing to remove surface defects;
- e-beam evaporation of a 1 nm Si passivation film, and
- sputter deposition of a stack of layers providing for the phase shift according to the present invention.

The invention has been described in detail as applied to the fabrication of specific AlGaAs ridge diode lasers with either cleaved or etched mirrors. It should, however, be understood that it is likewise applicable to other laser diode structures, and to devices consisting of compound semiconductors other than AlGaAs. Also, processes and device parameters may be different from those indicated herein above.

## Claims

1. A semiconductor laser diode (10, 20, 30), comprising
• a waveguide being terminated by a back facet (34) and a front facet (33),
• a front facet coating (31B) and a back facet coating (21A) having a reflectivity providing for controlled decoupling of light at said front facet (33) from a standing lightwave in said waveguide, the front facet coating (31 B) comprising a passivation layer in direct contact with said front facet (33),
said laser diode (30) being **characterized in that** said front facet coating (31B) additionally comprises a stack of layers (31B) providing for a phase shift of said standing lightwave within said waveguide such that the intensity of the standing lightwave at said front facet (33), where said light is decoupled from said standing lightwave, has a relative minimum.

2. The laser diode of claim 1, wherein said back facet coating (21A) also comprises a stack of layers providing for a phase shift of said standing lightwave within said waveguide such that the intensity of the lightwave at said back facet (34), where said lightwave is reflected back into the waveguide, has a relative minimum.

3. The laser diode of claim 1 or 2, wherein said stack of layers comprises a TiO₂ or an Al₂O₃ layer or TiO₂ and Al₂O₃ layers.

4. The laser diode of claim 1, wherein said stack of layers comprised in said front facet coating (31 B) has a reflectivity of about 10 %.

5. The laser diode of claim 2, wherein said stack of layers comprised in said back facet coating (21A) has a reflectivity of about 90 %.

6. The laser diode of claim 1, wherein said stack of layers comprises the following three layers:
• 60,0 mm (600 Å)TiO₂ with n=2.455,
• 270,0 mm (2700 Å)Al₂O₃ with n=1.65, and
• 60,0mm (600 Å) TiO₂ with n=2.455.

7. The laser diode of claim 1, having cleaved and/or etched facets (23, 33, 34).

8. The laser diode of claim 1, being a ridge waveguide laser, a broad area laser, or a buried waveguide laser.

9. The laser diode of claim 1, being a power laser of ≥1W.

10. Method for making a semiconductor laser diode (10, 20, 30) which comprises a waveguide being terminated by a back facet (34) and a front facet (33), a front facet coating (31B) and a back facet coating (21A) having a reflectivity providing for controlled decoupling of light at said front facet (33) from the standing lightwave in said waveguide,
comprising the steps of placing a passivation layer on said front facet (33); and thereafter forming a stack of layers serving as front facet coating (31B) by means of sputter deposition so as to provide for a phase shift of said standing lightwave within said waveguide such that the intensity of the lightwave at said front facet (33), where light is decoupled from said standing lightwave, has a relative minimum.

11. The method of claim 10, comprising the steps of sequentially forming the following three layers:
• 60,0 mm (600 Å) TiO₂ with n=2.455,
• 270,0 mm (2700 Å) Al₂O₃ with n=1.65, and
• 60,0 mm (600 Å) TiO₂ with n=2.455.

## Patentansprüche

1. Eine Halbleiterlaserdiode (10, 20, 30), umfassend
• einen Wellenleiter begrenzt durch eine hintere Facette (34) und eine vordere Facette (33),
• eine Beschichtung der vorderen Facette (31B) und eine Beschichtung der hinteren Facette (21A) mit einer Reflektivität, die ein gesteuertes Entkoppeln von Licht an genannter vorderer Facette (33) von einer stehenden Lichtwelle in dem genannten Wellenleiter ermöglicht, die Beschichtung der vorderen Facette (31B) eine Passivierungsschicht in direktem Kontakt mit der genannten vorderen Facette (33) umfassend,
wobei die Laserdiode (30) **dadurch gekennzeichnet ist, dass** die genannte Beschichtung der vorderen Facette (31B) zusätzlich einen Stapel an Schichten (31B) umfasst, die für eine Phasenverschiebung der genannten stehenden Lichtwelle innerhalb des genannten Wellenleiters sorgen, so dass die Intensität der stehenden Lichtwelle an genannter vorderer Facette (33), wo das genannte Licht von der stehenden Lichtwelle entkoppelt wird, ein relatives Minimum aufweist.

2. Die Laserdiode nach Anspruch 1, worin die genannte Beschichtung der hinteren Facette (21A) ebenfalls einen Stapel aus Schichten umfasst, die für eine Phasenverschiebung der genannten stehenden Lichtwelle innerhalb des genannten Wellenleiters sorgen, so dass die Intensität der Lichtwelle an genannter hinterer Facette (34), wo die genannte Lichtwelle zurück in den Wellenleiter reflektiert wird, ein relatives Minimum aufweist.

3. Die Laserdiode nach Anspruch 1 oder 2, worin der genannte Stapel an Schichten eine TiO₂ oder eine Al₂O₃ Schicht oder eine TiO₂ und eine Al₂O₃ Schicht aufweist.

4. Die Laserdiode nach Anspruch 1, worin der genannte Stapel an Schichten in der genannten Beschichtung der vorderen Facette (31B) eine Reflektivität von ungefähr 10% aufweist.

5. Die Laserdiode nach Anspruch 2, worin der genannte Stapel an Schichten in der genannten Beschichtung der hinteren Facette (21A) eine Reflektivität von ungefähr 90% aufweist.

6. Die Laserdiode nach Anspruch 1, worin der genannte Stapel an Schichten die folgenden drei Schichten umfasst:
• 60,0 nm (600 Å) TiO₂ mit n=2,455,
• 270,0 nm (2700 Å) Al₂O₃ mit n=1,65 und
• 60,0 nm (600 Å) TiO₂ mit n=2,455.

7. Die Laserdiode nach Anspruch 1 mit gespalteter und/oder geätzter Facette (23, 33, 34).

8. Die Laserdiode nach Anspruch 1, bei der es sich um einen Ridge Waveguide Laser, einen Broad Area Laser oder einen Buried Waveguide Laser handelt.

9. Die Laserdiode nach Anspruch 1, bei der es sich um einen Power Laser von ≥ 1W handelt.

10. Eine Methode zur Herstellung einer Halbleiterlaserdiode (10, 20, 30), welche einen Wellenleiter begrenzt durch eine hintere Facette (34) und eine vordere Facette (33), eine Beschichtung der vorderen Facette (31B) und eine Beschichtung der hinteren Facette (21A) umfasst mit einer Reflektivität, die ein gesteuertes Entkoppeln von Licht an genannter vorderer Facette (33) von einer stehenden Lichtwelle in dem genannten Wellenleiter ermöglicht,
folgende Schritte umfassend: Aufbringen einer Passivierungsschicht an der genannten vorderen Facette (33) und anschließend Bilden eines Stapels von Schichten, der als Beschichtung der vorderen Facette (31B) dient, mithilfe von Sputter-Aufbringung, um eine Phasenverschiebung der genannten stehenden Lichtwelle innerhalb des Wellenleiters zu erzeugen, so dass die Intensität der Lichtwelle an genannter vorderer Facette (33), wo das Licht von der genannten stehenden Lichtwelle entkoppelt wird, über ein relatives Minimum verfügt.

11. Die Methode nach Anspruch 10, die Schritte zur aufeinanderfolgenden Bildung der folgenden drei Schichten umfassend:
• 60,0 nm (600 Å) TiO₂ mit n=2,455,
• 270,0 nm (2700 Å) Al₂O₃ mit n=1,65 und
• 60,0 nm (600 Å) TiO₂ mit n=2,455.

## Revendications

1. Diode laser à semiconducteur (10, 20, 30), comprenant
• un guide d'onde qui se termine par une facette arrière (34) et une facette avant (33),
• un revêtement de facette avant (31B) et un revêtement de facette arrière (21A) présentant un facteur de réflexion permettant le découplage commandé de la lumière au niveau de ladite facette avant (33) à partir d'une onde lumineuse stationnaire dans ledit guide d'onde, le revêtement de facette arrière (31B) comprenant une couche de passivation en contact direct avec ladite facette avant (33),
ladite diode laser (30) étant **caractérisée en ce que** ledit revêtement de facette avant (31B) comprend en outre un empilement de couches (31B) permettant un déphasage de ladite onde lumineuse stationnaire à l'intérieur dudit guide d'onde de sorte que l'intensité de l'onde lumineuse stationnaire au niveau de ladite facette avant (33), où ladite lumière est découplée de ladite onde lumineuse stationnaire, présente un minimum relatif.

2. Diode laser selon la revendication 1, dans laquelle ledit revêtement de facette arrière (21 A) comprend également un empilement de couches permettant un déphasage de ladite onde lumineuse stationnaire à l'intérieur dudit guide d'onde de sorte que l'intensité de l'onde lumineuse au niveau de ladite facette arrière (34), où ladite onde lumineuse est réfléchie en retour dans le guide d'onde, présente un minimum relatif.

3. Diode laser selon la revendication 1 ou 2, dans laquelle ledit empilement de couches comprend une couche de TiO₂ ou de Al₂O₃ ou des couches de TiO₂ et de Al₂O₃.

4. Diode laser selon la revendication 1, dans laquelle ledit empilement de couches compris dans ledit revêtement de facette avant (31B) présente un facteur de réflexion d'environ 10 %.

5. Diode laser selon la revendication 2, dans lequel ledit empilement de couches compris dans ledit revêtement de facette arrière (21A) présente un facteur de réflexion d'environ 90 %.

6. Diode laser selon la revendication 1, dans lequel ledit empilement de couches comprend les trois couches suivantes :
• 60,0 nm(600 Å) de TiO₂ avec n = 2,455,
• 270,0 nm(2 700 Å) de Al₂O₃ avec n = 1,65, et
• 60,0 nm(600 Å) de TiO₂ avec n = 2,455.

7. Diode laser selon la revendication 1, comportant des facettes clivées et/ou gravées (23, 33, 34).

8. Diode laser selon la revendication 1, qui est un laser à guide d'onde nervuré, un laser à large surface, ou un laser à guide d'onde enterré.

9. Diode laser selon la revendication 1, qui constitue un laser de puissance ≥ 1 W.

10. Procédé destiné à réaliser une diode laser à semiconducteur (10, 20, 30) qui comprend un guide d'onde qui est terminé par une facette arrière (34) et une face avant (33), un revêtement de facette avant (31B) et un revêtement de facette arrière (21A) présentant un facteur de réflexion permettant un découplage commandé de la lumière au niveau de ladite facette avant (33) de l'onde lumineuse stationnaire dans ledit guide d'onde,
comprenant les étapes consistant à placer une couche de passivation sur ladite facette avant (33), et
à former ensuite un empilement de couches servant de revêtement de facette avant (31B) au moyen d'un dépôt par pulvérisation de façon à permettre un déphasage de ladite onde lumineuse stationnaire à l'intérieur dudit guide d'onde de sorte que l'intensité de l'onde lumineuse au niveau de ladite facette avant (33), où la lumière est découplée de ladite onde lumineuse stationnaire, présente un minimum relatif.

11. Procédé selon la revendication 10, comprenant les étapes consistant à former séquentiellement les trois couches suivantes :
• 60,0 nm(600 Å) de TiO₂ avec n = 2,455,
• 270,0 nm(2 700 Å) de Al₂O₃ avec n = 1,65, et
• 60,0 nm(600 Å) de TiO₂ avec n = 2,455.
